(19) Europäisches Patentamt
European Patent Office
Office européen des brevets

(11) **EP 4 133 419 B1**

(12) **EUROPÄISCHE PATENTSCHRIFT**

(45) Veröffentlichungstag und Bekanntmachung des Hinweises auf die Patenterteilung:
**26.03.2025 Patentblatt 2025/13**

(21) Anmeldenummer: **21731993.8**

(22) Anmeldetag: **08.06.2021**

(51) Internationale Patentklassifikation (IPC):
*G06N 3/065* (2023.01)    *H01L 29/51* (2006.01)
*H01L 29/78* (2006.01)    *H01L 29/417* (2006.01)

(52) Gemeinsame Patentklassifikation (CPC):
**H10D 64/647; G06N 3/065; H10D 30/611; H10D 30/701; H10D 64/258; H10D 64/689**

(86) Internationale Anmeldenummer:
**PCT/EP2021/065297**

(87) Internationale Veröffentlichungsnummer:
**WO 2021/254830 (23.12.2021 Gazette 2021/51)**

(54) **NEURONEN UND SYNAPSEN MIT FERROELEKTRISCH MODULIERTEN METALL-HALBLEITER SCHOTTKY DIODEN NEBST VERFAHREN**

NEURONS AND SYNAPSES HAVING FERROELECTRICALLY MODULATED METAL-SEMICONDUCTOR SCHOTTKY DIODES, AND METHOD

NEURONES ET SYNAPSES AYANT DES DIODES SCHOTTKY À MÉTAL-SEMI-CONDUCTEUR À MODULATION ÉLECTRIQUE, ET PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.06.2020 DE 102020207439**

(43) Veröffentlichungstag der Anmeldung:
**15.02.2023 Patentblatt 2023/07**

(73) Patentinhaber: **Forschungszentrum Jülich GmbH 52425 Jülich (DE)**

(72) Erfinder: **ZHAO, Qing-Tai 52428 Jülich (DE)**

(74) Vertreter: **Gille Hrabal Partnerschaftsgesellschaft mbB Patentanwälte Brucknerstraße 20 40593 Düsseldorf (DE)**

(56) Entgegenhaltungen:
**WO-A1-2019/139598     US-A1- 2019 198 617**

- **TANG BIN ET AL: "Novel Type of Synaptic Transistors Based on a Ferroelectric Semiconductor Channel", APPLIED MATERIALS & INTERFACES, vol. 12, no. 22, 11 May 2020 (2020-05-11), US, pages 24920 - 24928, XP055840003, ISSN: 1944-8244, Retrieved from the Internet <URL:https://pubs.acs.org/doi/pdf/10.1021/acsami.9b23595> [retrieved on 20241111], DOI: 10.1021/acsami.9b23595**
- **TANG BIN ET AL: "Novel Type of Synaptic Transistors Based on a Ferroelectric Semiconductor Channel", APPLIED MATERIALS & INTERFACES, vol. 12, no. 22, 11 May 2020 (2020-05-11), US, pages 24920 - 24928, XP055840003, ISSN: 1944-8244, Retrieved from the Internet <URL:https://pubs.acs.org/doi/pdf/10.1021/acsami.9b23595> [retrieved on 20210913], DOI: 10.1021/acsami.9b23595**

**Beschreibung**

Die Erfindung betrifft ein synaptisches Bauteil für ein neuronales Netzwerk. Mit synaptischem Bauteil ist ein elektronisches Bauteil gemeint, das Eigenschaften einer biologischen Synapse aufweist. Nachfolgend wird das elektronische Bauteil daher auch Synapse genannt. Mit neuronalem Netzwerk ist ein künstliches neuronales Netzwerk gemeint.

Ein Gehirn ist ein biologisches neuronales Netzwerk. Es umfasst eine Vielzahl von biologischen Neuronen, also Nervenzellen. Ein biologisches Neuron kann über biologische Synapsen eine Information an ein anderes biologisches Neuron senden. Dies geschieht mithilfe eines Ausgangskanals des biologischen Neurons. Ein solcher Ausgangskanal wird Axon genannt. Das andere biologische Neuron verfügt über einen Eingangskanal. Der Eingangskanal wird Dendrit genannt. Über den Eingangskanal kann das andere biologische Neuron die Information empfangen. Die Entscheidung darüber, ob ein biologisches Neuron ein Aktionspotential über sein Axon auslöst und damit eine Information sendet, hängt von der Gesamtheit der eingehenden Signale ab. Der Einfluss eines biologischen Neurons auf ein anderes biologisches Neuron kann sich bei biologischen Synapsen im Laufe der Zeit mit ihrer Aktivität ändern. Ein solcher Einfluss wird "synaptisches Gewicht" eines biologischen Neurons bezeichnet.

Die Eigenschaften und Verhaltensweisen eines neuronalen Netzwerks sollen den Eigenschaften und Verhaltensweisen eines biologischen neuronalen Netzwerks ähneln. Ein neuronales Netzwerk soll mittels lernfähiger Algorithmen Muster erkennen können. Ein neuronales Netz soll, vergleichbar mit dem menschlichen Gehirn, nicht für jede Aufgabe oder jedes Problem von vorne beginnen müssen. Es soll die Möglichkeit haben, auf bereits erworbenes Wissen und schon gemachte Erfahrungen zurückzugreifen.

In der Druckschrift WO 2019/139598 A1 wird eine Vorrichtung beschrieben, die umfasst: ein erstes Gate, das umfasst: eine erste Struktur, die ein erstes ferroelektrisches Material umfasst; und eine zweite Struktur neben der ersten Struktur, wobei die zweite Struktur eine erste Gate-Elektrode umfasst; eine Source neben dem ersten Gate; ein zweites Gate, das umfasst: eine dritte Struktur, die ein zweites ferroelektrisches Material umfasst; und eine vierte Struktur neben der dritten Struktur, wobei die vierte Struktur eine zweite Gate-Elektrode umfasst; einen Drain neben dem zweiten Gate; und einen Halbleiterkörper neben dem ersten und dem zweiten Gate und zwischen der Source und dem Drain.

Die Druckschrift "Novel Type of Synaptic Transistors Based on a Ferroelectric Semiconductor Channel, Bin Tang, Sabir Hussain, Rui Xu, Zhihai Cheng, Jianhui Liao*, and Qing Chen*, ACS Appl. Mater. Interfaces 2020, 12, 22, 24920-24928, https://doi.org/10.1021/acsami.9b23595", offenbart einen dreipoligen synaptischen Transistor für neuromorphe Systeme, der auf zweidimensionalen ferroelektrischen Halbleitern basiert.

Die Druckschrift US 2019/198617 A1 beschreibt ein Verfahren und resultierende Strukturen für eine Halbleitervorrichtung mit einem steuerbaren Widerstand. Ein beispielhaftes Verfahren zum Bilden einer Halbleitervorrichtung umfasst das Bilden eines Source-Anschlusses und eines Drain-Anschlusses eines Feldeffekttransistors (FET) auf einem Substrat. Der Source-Anschluss und der Drain-Anschluss sind auf beiden Seiten eines Kanalbereichs ausgebildet. Angrenzend an den Source-Anschluss und den Kanalbereich wird eine Energiebarriere gebildet. Über dem Kanalbereich wird ein leitendes Gate gebildet.

Ein neuronales Netzwerk mit Memristoren ist aus der Druckschrift CN 208922326 U bekannt. Skalierung, Stabilität und Sperrfähigkeit sind bei einem neuronalen Netzwerk mit Memristoren problematisch.

Die Druckschrift WO 2019147859 A2 offenbart ein elektronisches Bauteil mit einem Halbleiterkanal. An ein Ende des Halbleiterkanals grenzt eine Eingangselektrode an. An das andere Ende des Halbleiterkanals grenzt eine Ausgangselektrode an. Oberhalb des Halbleiterkanals gibt es eine Schicht aus dielektrischem Material. Ein als Synapse dienender Schaltkreis aus Halbleitermaterialien mit einem elektrisch geladenen Trägergas wird in der Druckschrift EP 0 529 565 B1 beschrieben. Ein integrierter Schaltkreis für die Bereitstellung einer Synapse ist aus der Druckschrift US 2019164597 A1 bekannt.

Soll ein neuronales Netzwerk mit konventioneller CMOS Technologie realisiert werden, so wird eine Vielzahl an Transistoren benötigt. Herstellungsaufwand und Energieverbrauch sind dann hoch. Ein neuronales Netzwerk kann ferroelektrische Feldeffekttransistoren (FeFET) umfassen. Traditionelle ferroelektrische Materialien wie Blei-Zirkonat-Titanat (PZT) sind schädlich für die Umwelt und inkompatibel zur etablierten CMOS Technologie.

Es ist Aufgabe der Erfindung, eine Synapse, also ein synaptisches Bauteil mit verbesserten Eigenschaften zu schaffen.

Zur Lösung der Aufgabe dient ein synaptisches Bauteil mit den Merkmalen von Patentanspruch 1. Die abhängigen Ansprüche betreffen vorteilhafte Ausgestaltungen der Erfindung. Der nebengeordnete Anspruch betrifft ein Verfahren für den Betrieb des synaptischen Bauteils.

Patentanspruch 1 betrifft ein synaptisches Bauteil für ein neuronales Netzwerk. Das synaptische Bauteil umfasst eine Schicht, die aus einem Halbleiter besteht. Die aus einem Halbleiter bestehende Schicht wird halbleitende Schicht genannt. Eine Source - Elektrode ist mit der halbleitenden Schicht verbunden. Eine Drain - Elektrode ist mit der halbleitenden Schicht verbunden. Die Source - Elektrode ist von der Drain - Elektrode räumlich getrennt. Die Source - Elektrode und die halbleitende Schicht bilden eine Schottky - Diode. Die Source - Elektrode ist von einer ersten Gate - Elektrode durch ferroelektrisches Material getrennt. Die Drain - Elektrode kann von einer zweiten Gate - Elektrode durch ferroelektrisches Material getrennt sein. Die beiden Gate - Elektroden sind räumlich voneinander getrennt.

Eine Elektrode ist von einer anderen Elektrode getrennt, wenn es einen Abstand zwischen den beiden Elektroden gibt. Räumlich getrennte Elektroden berühren sich also nicht. Es gibt daher keine elektrisch leitende Verbindung zwischen den beiden Elektroden. Mithilfe des ferroelektrischen Materials kann eine an die erste Gate - Elektrode angelegte elektrische Spannung auf die Source - Elektrode übertragen werden. Entsprechendes gilt für den Fall, dass eine zweite Gate - Elektrode von der Drain - Elektrode durch ferroelektrisches Material getrennt ist. In der Regel befindet sich die eine Gate - Elektrode an einer Seite des ferroelektrischen Materials und die andere Source- bzw. Drain - Elektrode auf einer gegenüberliegenden Seite des ferroelektrischen Materials. Die beiden Elektroden können mit dem ferroelektrischen Material unmittelbar verbunden sein. Die Erfindung nutzt die Memory-Eigenschaften von ferroelektrischem Material aus, um das Verhalten einer biologischen Synapse nachzuahmen.

Eine Schottky-Diode kann eine Metallschicht umfassen, die auf einer halbleitenden Schicht wie zum Beispiel einer Siliziumschicht aufgebracht ist. Eine Metallschicht ist eine Schicht, die aus Metall besteht. Eine Siliziumschicht ist eine Schicht, die aus Silizium besteht. Silizium ist ein Halbleiter, also ein chemischer Stoff, dessen elektrische Leitfähigkeit zwischen der von elektrischen Leitern und der von elektrischen Isolatoren liegt.

Die Siliziumschicht kann beispielsweise n - Silizium, also eine n-Typ dotierte Siliziumschicht sein. Elektronen der n-leitenden Siliziumschicht wandern zur Metallschicht. Weil Elektronen leichter aus n-leitendem Silizium in die Metallschicht gelangen als umgekehrt, entsteht in der Siliziumschicht ein an Elektronen verarmter Bereich. Dieser Bereich wird Schottky-Sperrschicht genannt. Es entsteht also eine Sperrschicht bzw. eine Raumladungszone. Außerdem entsteht ein elektrisches Feld. Das elektrische Feld wirkt der Wanderung der Elektroden entgegen. Ist das elektrische Feld groß genug, so wandern keine Elektronen mehr von der n-leitenden Siliziumschicht zur Metallschicht. Die Siliziumschicht kann aber auch p - Silizium, also eine p-Typ dotierte Siliziumschicht sein.

Wird eine positive elektrische Spannung an n-leitendes Silizium angelegt und eine negative elektrische Spannung an die Metallschicht, dann wird die Raumladungszone größer. Die Schottky - Diode ist dann in Sperrrichtung geschaltet.

Wird eine elektrisch negative Spannung an n-Silizium angelegt und eine elektrisch positive Spannung an die Metallschicht, dann ist die Schottky - Diode in Durchflussrichtung geschaltet. Elektronen fließen von n-Silizium in die Metallschicht. Ist die Schottky-Diode in Durchlassrichtung geschaltet, dann wird die Raumladungszone freigeräumt.

Eine Elektrode ist ein elektrischer Leiter. Eine Elektrode besteht grundsätzlich aus Metall.

Eine erfindungsgemäße Schicht kann geradlinig verlaufen, also entlang einer Ebene. Eine erfindungsgemäße Schicht kann aber auch rund verlaufen und/oder eckig verlaufen.

Mit dem Bauteil mit den Merkmalen des Patentanspruchs 1 kann das Verhalten einer biologischen Synopse nachgeahmt werden. Das Bauteil kann mit technisch geringem Aufwand hergestellt werden. Das Bauteil kann aus umweltfreundlichen Materialien hergestellt werden.

Die Source - Elektrode und die Drain - Elektrode können auf einer Seite der halbleitenden Schicht sein. Auf technisch einfache Weise kann ein solches Bauteil hergestellt werden. Die Source - Elektrode und die Drain - Elektrode können auf einer Oberfläche der halbleitenden Schicht durch Abscheidung hergestellt werden.

Die Source - Elektrode und die Drain - Elektrode können bei gegenüberliegenden Enden der halbleitenden Schicht sein. Es kann so ein geeigneter Abstand zwischen der Source - Elektrode und der Drain - Elektrode bereitgestellt werden.

Um das Bauteil auf technisch einfache Weise herzustellen, kann das Bauteil ein Substrat umfassen. Oberhalb des Substrats ist dann die halbleitende Schicht aufgebracht. Die halbleitende Schicht kann eine dünne Schicht sein. Das Substrat kann aus Silizium bestehen. Zwischen dem Substrat und dem Halbleiter kann sich eine elektrisch isolierende Schicht befinden. Durch die elektrisch isolierende Schicht können störende Einflüsse vermieden werden.

Ferroelektrisches Material des Bauteils kann in Form einer Schicht vorliegen. Auf der Source - Elektrode kann also eine Schicht aus ferroelektrischem Material aufgebracht sein. Auf der Drain - Elektrode kann also eine Schicht aus ferroelektrischem Material aufgebracht sein. Eine ferroelektrische Schicht kann sich teilweise auf der halbleitenden Schicht befinden, um eine technisch einfache Herstellung zu ermöglichen. Eine ferroelektrische Schicht kann sich teilweise auf der Source- Elektrode bzw. Drain - Elektrode befinden. Es müssen nicht zwingend zwei räumlich voneinander getrennte Schichten aus ferroelektrischen Material vorhanden sein. Es kann sich um eine einzige Schicht aus ferroelektrischen Material handeln, die sich zumindest teilweise auf der Source - Elektrode und zumindest teilweise auf der Drain - Elektrode befindet. Auch dies kann die Herstellung erleichtern.

Auf der gegenüberliegenden Seite einer solchen ferroelektrischen Schicht kann eine erste und/oder zweite Gate - Elektrode aufgebracht sein. Die erste Gate - Elektrode und/ oder die zweite Gate - Elektrode befinden sich auf einer Seite der ferroelektrischen Schicht. Die Source - Elektrode und/oder die Drain - Elektrode befinden sich auf der gegenüberliegenden Seite der ferroelektrischen Schicht.

Eine aus Metall bestehende Drain - Elektrode kann als Substrat des synaptischen Bauteils dienen. Auf dem Substrat kann zunächst Halbleitermaterial aufgetragen sein. Oberhalb des Halbleitermaterials kann das Metall für eine Source - Elektrode aufgetragen sein. Auf der Source - Elektrode kann ferroelektrisches Material aufgetragen sein. Auf dem ferroelektrischen Material kann Metall für eine Gate - Elektrode aufgetragen sein. Eine vertikale Bauweise ist so möglich.

Es können ein oder mehrere elektrisch isolierende Schichten während der Herstellung vorgesehen werden, um ein synaptisches Bauteil auf technisch einfache Weise herzustellen. So kann eine isolierende Schicht mit Ausnehmungen auf einer halbleitenden Schicht aufgetragen werden. Durch die Ausnehmungen hindurch kann die halbleitende Schicht kontaktiert werden. Die Ausnehmungen können zumindest teilweise mit Metall beschichtet werden, um so beispielsweise Schottky - Dioden herzustellen. Die isolierende Schicht mit den Ausnehmungen trägt dazu bei, dass die beiden Elektroden elektrisch voneinander getrennt sind. Auch bei einer vertikalen Bauweise kann die Herstellung von ein oder mehreren isolierenden Schichten von Vorteil sein. Die elektrisch isolierende Schicht kann das Halbmaterial bedecken, soweit das Halbleitermaterial nicht durch metallische Elektroden kontaktiert werden soll.

Es können auf einfache Weise eine Vielzahl von synaptischen Bauteilen hergestellt werden, die elektrisch parallel und/ oder elektrisch seriell miteinander verbunden sind. Es kann eine sogenannte Crossbarstruktur hergestellt werden, die in neuronalen Netzwerken von Vorteil sein kann.

Das Halbleitermaterial kann ausgewählt sein aus: Si, Ge, SiGe, SiGeSn, GeSn, SiC. Das Halbleitermaterial kann ein III-V - Verbindungshalbleiter, II-VI - Verbindungshalbleiter sein. Das Halbleitermaterial kann ein 2D Material sein, welches also aus nur einer Lage oder nur aus wenigen Lagen von Atmen und Molekülen besteht. Das Halbleitermaterial kann ein Substrat oder eine Halbleiterschicht auf einem Substrat, wie z.B. ein "Silicon-On-Insulator" (SOI), sein. Mit Substrat ist eine selbsttragende Schicht gemeint, die daher als Träger für andere Schichten dienen kann. Für eine Herstellung des Bauteils kann daher von einem Substrat ausgegangen werden, auf welches weitere Schichten aufgetragen werden können. Das Halbleitermaterial kann eine Halbleiterheterostruktur mit mehreren Halbleiterschichten sein.

Das ferroelektrische Material kann ausgewählt sein aus: $HfO_2$ basiertes Ferroelektrikum, perowskitisches Ferroelektrikum und organisches Ferroelektrikum. Das ferroelektrische Material, so zum Beispiel $HfO_2$ basiertes Ferroelektrikum, kann dotiert sein. Eine Dotierung kann mit ein oder mehreren der folgenden Elementen erfolgt sein: N, Al, Si, Sc, Ge, Y, Zr, Gd, Pr, Sr, Tb, La, Lu.

Das Metall für die Schottky - Diode kann ausgewählt sein aus: Al, Ag, Au, Cu, Cr, Mo, Ni, Nb, Pt, Ti, Ni, TiN, TaN, und Metalllegierungen. Das Metall für die Schottky - Diode kann eine Metallhalbleiterlegierung sein wie Silizide, Germanide, Metall-SiGeSn-Lagierungen.

Durch die Erfindung können künstliche synaptische Bauelemente basierend auf Metall / Halbleiter Schottky Barrieren bereitgestellt werden. Die Polarisierung der ferroelektrischen Schichten führt zu einer abschirmenden Ladung an der Metall / Halbleiter Grenzfläche, so dass die effektive Stärke der Schottky Barriere in dem Metall- / Halbleiter-Kontakt moduliert wird. Die Polarisationsumschaltungen in Multidomänensystemen induzieren Viellevelladungsverteilungen an der Metall-Halbleiter Grenzschicht, wodurch eine Multiebenenleitung der Diode verursacht wird. Dies kann ausgenutzt werden, um Eigenschaften von Synapsen nachzuahmen.

Die vorliegende Erfindung löst das Problem von Interfacefallen an dem Interface zwischen ferroelektrischem und halbleitendem Material in FeFETs, denn das ferroelektrische Material wird primär auf dem Metall angeordnet. Die erfindungsgemäßen ferroelektrischen Bauelemente können bei relativ geringen Temperaturen (<800°C) nach dem CMOS Prozess hergestellt werden. Dadurch sind fast alle ferroelektrischen Materialien nutzbar.

Die Erfindung liefert eine Methode zum Aufbau von künstlichen Synapsen, die nach folgendem Muster hergestellt sein können. Diese können zwei rückseitig verbundenen Metall- / Halbleiter-Schottky - Dioden umfassen, welche mit einer ferroelektrischen Lage und einer Gate - Elektrode kontaktiert sind. Dabei kann die Stärke der ferroelektrischen Schicht auf beiden Schottky - Dioden identisch oder unterschiedlich sein. Dies gilt ebenso für die Auswahl des Materials für die ferroelektrischen Schicht. Die eine Schottky - Diode kann als Signalinput fungieren, während mit der zweiten Schottky - Diode das synaptische Gewicht geregelt werden kann. Durch eine konstante Vorspannung an der zweiten Schottky - Diode kann das synaptische Gewicht auch über die Regelspannung an der ersten Schottky - Diode eingestellt werden. In einem Ausführungsbeispiel, welches nicht in den Schutzumfang der anhängigen Ansprüche fällt, kann anstelle einer zweiten Schottky - Diode ein Metall - Halbleiter - Übergang vorhanden sein, der wie ein ohmscher Kontakt wirkt.

Zusätzliche Effekte treten bei künstlichen Synapsen mit umgepolter Vorspannung der Metall-/ Halbleiter-Schottky Diode auf, welche mit einer ferroelektrischen Schicht überzogen sind. Hier kann die Drain - Elektrode durch einen ohmschen Kontakt an dem Halbleiter realisiert sein.

Die Erfindung betrifft außerdem ein Verfahren für den Betrieb eines erfindungsgemäßen synaptischen Bauteils. Die erste Schottky - Diode wird während des Betriebs in Sperrrichtung geschaltet wird. An die erste Gate - Elektrode wird eine elektrische Spannung pulsförmig angelegt. Das synaptische Bauteil verhält sich dann wie eine biologische Synapse.

Es zeigen

Figur 1:    Funktionsprinzip eines neuronalen Gates;

Figur 2a:   Ausführungsform einer Synapse;

Figur 2b:   Symboldarstellung der Synapse nach Figur 2a;

Figur 3:    Ausführungsform einer Synapse;

Figur 4a:   Modulation einer Schottky - Diode durch eine positive Gate - Spannung;

Figur 4b:   Modulation einer Schottky - Diode durch eine negative Gate - Spannung;

Figur 5a:   Bändermodell einer Schottky - Diode bei positiver Gate - Spannung;

Figur 5b:   Bändermodell einer Schottky - Diode bei negativer Gate - Spannung;

Figur 6a:   Strom - Spannungskurve;

Figur 6b:   Ausführungsform einer Synapse;

Figur 7:    Puls - Strom - Diagramm;

Figur 8a:   Ausführungsform für eine Mehrzahl von Synapsen

Figur 8b:   Schnittdarstellung aus Figur 8a;

Figur 9a:   Ausführungsform einer Synapse;

Figur 9b:   Symboldarstellung der Synapse aus Figur 9a;

Figur 10:   Vertikale Anordnung eines synaptischen Bauelements;

Figur 11a, b:   Symboldarstellungen eines neuronalen Bauelements;

Figur 12:   neuronales Netzwerk;

Figur 13:   Realdarstellung einer Synapse;

Figur 14:   NAND-Gatter;

Figur 15:   AND-Gatter.

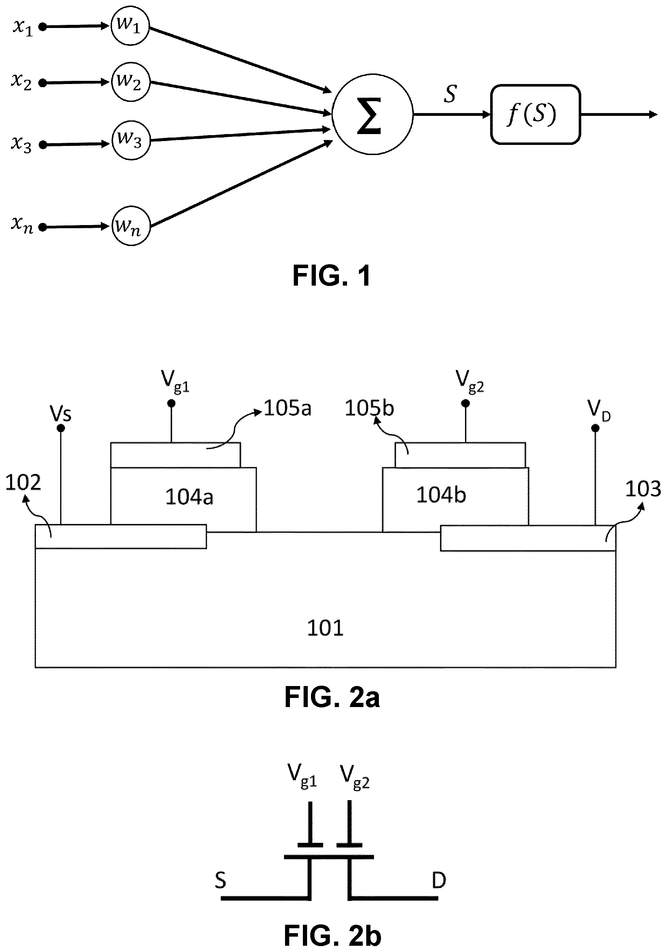

Fig.1 zeigt das Funktionsprinzip eines neuronalen Gates, welches aus mehreren Eingangssynapsen $x_1$ bis $x_n$ und einem Neuron besteht. Die Eingangssignale der Synapsen $x_i$ mit den Gewichten $w_i$ werden mit folgender Funktion integriert:

$$S = \sum_{i=1}^{n} x_i w_i + \theta$$

**S ist hier** die Integration über die Eingangssignale mit den zugehörigen Gewichten und $\theta$ ist ein Offset. Die neuronale Funktion $f(s)$ wirkt als Schwellwertfunktion. Sobald $S$ *einen* Schwellwert erreicht, wird das Neuron mit der Funktion $f(s)$ aktiviert.

Fig. 2 zeigt eine erste Ausführungsform einer Synapse. Die Synapse umfasst eine Schicht 101, die aus einem Halbleiter besteht. Auf der halbleitenden Schicht 101 befinden sich eine Source - Elektrode 102 und eine Drain - Elektrode 103. Die beiden Elektroden 102, 103 sind räumlich voneinander getrennt. Die beiden Elektroden 102, 103 können angrenzend an die Stirnseiten der halbleitenden Schicht 101 vorhanden sein. Die beiden Elektroden 102, 103 bestehen aus Metall. Die beiden Elektroden 102, 103 können schichtförmig sein. Ein elektrisches Potential $V_S$ kann an die Source-Elektrode 102 angelegt werden. Ein elektrisches Potential $V_D$ kann an die Drain-Elektrode 103 angelegt werden. Das elektrische Potential $V_S$ unterscheidet sich von dem elektrischen Potential $V_D$.

Das Metall der Source-Elektrode 102 und das Halbleitermaterial der halbleitenden Schicht 101 sind so ausgewählt, dass der Übergang zwischen der Source-Elektrode 102 und der halbleitenden Schicht 101 ein Schottky - Kontakt ist. Es liegt also eine erste Schottky - Diode vor, die durch die Source-Elektrode 102 und die halbleitende Schicht 101 gebildet wird.

Das Metall der Drain-Elektrode 103 und das Halbleitermaterial der halbleitenden Schicht 101 können so ausgewählt sein, dass der Übergang zwischen der Drain-Elektrode 103 und der halbleitenden Schicht 101 ein Schottky - Kontakt ist. Die Drain-Elektrode 103 und die halbleitende Schicht 101 können also eine zweite Schottky - Diode bilden.

Die erste Schottky-Diode und die zweite Schottky-Diode sind in einer Ersatzschaltung "backto-back" geschaltet. Eine Potentialdifferenz zwischen dem elektrischen Potential $V_S$ und dem elektrischen Potential $V_D$ hat daher zur Folge, dass eine Schottky - Diode in Sperrrichtung geschaltet ist und die andere Schottky - Diode in Durchlassrichtung.

Es kann aufgrund der Potentialdifferenz zwischen dem elektrischen Potential $V_S$ und dem elektrischen Potential $V_D$ ein elektrischer Strom von der Source-Elektrode 102 zur Drain-Elektrode 103 fließen. Fließt ein elektrischer Strom von der Source - Elektrode 102 zur Drain - Elektrode 103, so passiert der elektrische Strom die erste Schottky - Diode in Sperrrichtung und die zweite Schottky - Diode in Durchlassrichtung. Das Fließen des elektrischen Stroms in Sperrrichtung kann erfolgen, indem Elektronen die Sperrschicht der ersten Schottky - Diode durchtunneln. Fließt der elektrische Strom in Durchlassrichtung durch die zweite Schottky - Diode, so wirkt die zweite Schottky - Diode wie ein ohmscher Widerstand.

Oberhalb der Source - Elektrode 102 befindet sich eine erste ferroelektrische Schicht 104a. Die erste ferroelektrische Schicht 104a kann einen Teil der Source - Elektrode 102 überdecken. Die erste ferroelektrische Schicht 104a überlappt mit der halbleitenden Schicht 101.

Oberhalb der Drain - Elektrode 103 befindet sich eine zweite ferroelektrische Schicht 104b. Die zweite ferroelektrische Schicht 104b überdeckt einen Teil der Source - Elektrode 103. Die zweite ferroelektrische Schicht 104b überlappt mit der halbleitenden Schicht 101.

Auf der ersten ferroelektrischen Schicht 104a befindet sich eine erste Elektrode 105a. Auf der zweiten ferroelektrischen Schicht 104b befindet sich eine zweite Elektrode 105b. Beide Elektroden 105a und 105b können aus Metall bestehen.

Die Synapse ist so eingerichtet, dass an die erste Elektrode 105a ein elektrisches Potential $V_{g1}$ angelegt werden kann. Durch ein angelegtes elektrisches Potential $V_{g1}$ kann die Schottky-Barriere der ersten Schottky - Diode moduliert werden. Die Synapse ist so eingerichtet, dass an die zweite Elektrode 105a ein elektrisches Potential $V_{g2}$ angelegt werden kann. Durch ein angelegtes elektrisches Potential $V_{g2}$ kann die Schottky-Barriere der zweiten Schottky - Diode moduliert werden.

Das erste elektrische Potential $V_{g1}$ kann als synaptisches Eingangssignal innerhalb eines neuronalen Netzwerks aufgefasst werden. Das zweite elektrische Potential $V_{g2}$ kann zur Regelung von Gewichten innerhalb eines neuronalen Netzwerks verwendet werden.

Die ferroelektrischen Schichten 104a und/oder 104b können Bereiche der Elektroden 102 und 103 überlappen, die auf der halbleitenden Schicht 101 aufgebracht sind. Es kann so die Herstellung erleichtert werden. Auch können die Schottky - Barrieren der ersten und zweiten Schottky - Dioden kontrollierter moduliert werden.

Die Figur 2b zeigt ein elektrisches Symbol der in der Figur 2a gezeigte Synapse mit der Source - Elektrode S und der Drain - Elektrode D.

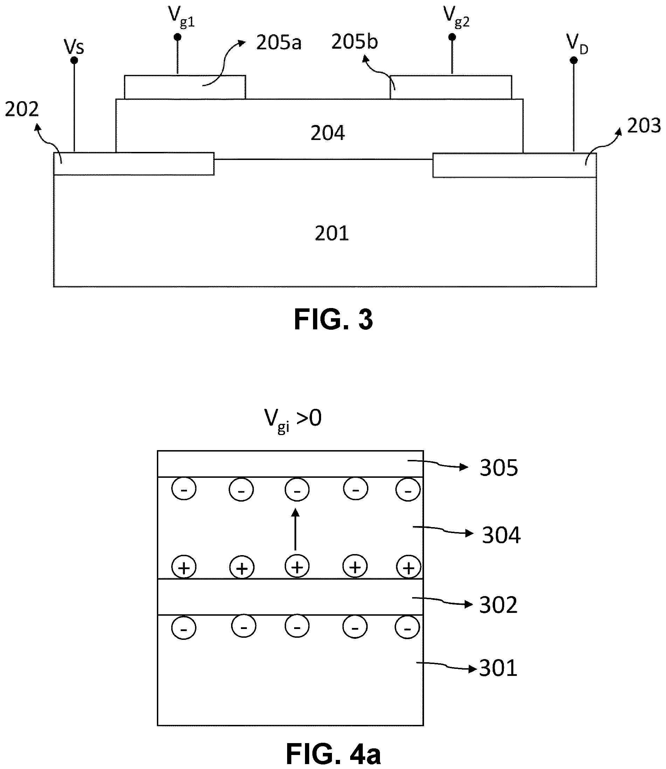

In der Fig. 3 wird eine zweite Ausführungsform einer Synapse gezeigt, die anstelle von zwei ferroelektrischen Schichten 204a und 204b nur eine durchgehende ferroelektrische Schicht 204 aufweist. Darüber hinaus verfügt die hier gezeigte Synapse über eine Schicht 201, die aus einem Halbleiter besteht. Auf der halbleitenden Schicht 201 befinden sich wie im Fall der Figur 2a eine Source - Elektrode 202 und eine Drain - Elektrode 203. Das Metall der Source-Elektrode 202 und das Halbleitermaterial der halbleitenden Schicht 201 sind so ausgewählt, dass der Übergang zwischen der Source - Elektrode 202 und der halbleitenden Schicht 201 ein Schottky - Kontakt ist. Das Metall der Drain - Elektrode 203 und das Halbleitermaterial der halbleitenden Schicht 201 können so ausgewählt sein, dass der Übergang zwischen der Drain-Elektrode 203 und der halbleitenden Schicht 201 ein Schottky - Kontakt ist. Auf der ferroelektrischen Schicht 204 befinden sich eine erste Elektrode 205a und eine zweite Elektrode 205b. Das elektrische Symbol der Figur 2b kann auch die in der Figur 3 gezeigte Synapse repräsentieren.

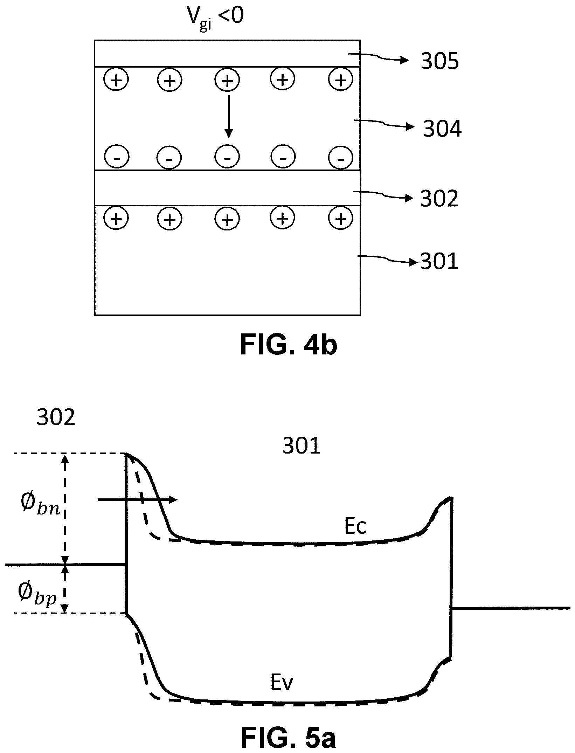

Die Figuren 4a und 4b verdeutlichen das Modulieren der Schottky - Barrieren durch Anlegen eines elektrischen Potentials $V_{gi}$, wobei $V_{gi}$ mit i = 1 oder i =2. Figur 4a zeigt den Fall, dass eine an der Elektrode 305 angelegte Spannung bzw. angelegtes elektrisches Potential positiv ist. Die Polarisation des Ferroelektrikums verursacht nichtflüchtige Speichereffekte, so dass Elektronen in der Halbleiterschicht 301 vorhanden sind. Die Figur 4b verdeutlicht die Situation, wenn eine negative Spannung $V_{gi}$ an die erste bzw. zweite Elektrode 305 angelegt wird, wobei positive Ladungen (Löcher) in der Halbleiterschicht 301 aufgrund polarisationsbedingter nichtflüchtiger Speichereffekte vorhanden sind. Die Dicke einer Schottky - Barriere kann folglich durch Anlegen von Potentialen $V_{gi}$ moduliert werden. Dies wirkt sich auf das Fließen von elektrischen Tunnelströmen aus.

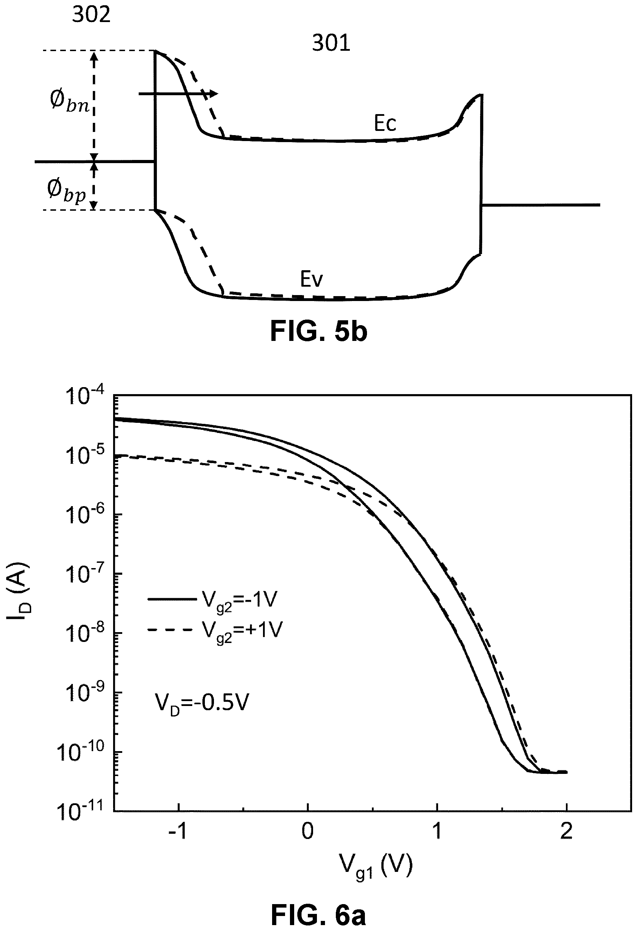

Figur 5 verdeutlicht anhand des Bändermodells eine Modulierung einer Schottky Barriere von der in der Figur gezeigten Metallschicht 302 zu der n-Typ dotierten halbleitenden Schicht 301. Wenn eine positive Spannung $V_{gi}$ angelegt wird, wie es in Fig. 4a gezeigt wird, werden mehr Elektronen werden an der Metall-Halbleiter-Grenzschicht erzeugt. Die Bandkrümmung (gestrichelte Linie) wird verstärkt. Es resultiert eine kleinere Schottky Barriere. Dies verursacht entlang des Pfeils eine höhere Tunnelstromdichte, welche wie folgt formuliert werden kann:

$$J_t \sim \exp(-\frac{q\emptyset_{bn}}{\sqrt{N_D}})$$

Hier ist $\emptyset_{bn}$ ist die Höhe der Schottky Barriere für die Elektronen. $q$ ist die Ladung der Elektronen. $N_D$ ist die Dotierungskonzentration an der Oberfläche des Halbleiters 301.

Wird die in der Figur 4b gezeigt eine negative Spannung $V_{gi}$, bewirkt die Verarmung ein kleineres $N_D$ und damit eine breitere Schottky Barriere. Eine kleinere Stromdichte entlang des Pfeils ist die Folge. So kann durch die Modulation der Multidomänenpolarisation des Ferroelektrikums die Dotierungskonzentration in der Metall-Halbleiter-Grenzschicht reguliert werden und damit die Leitfähigkeit der Schottky Diode.

Für einen p-Typ dotierten Halbleiter zeigt die Polarisation und die Vorspannung in die entgegengesetzte Richtung. Die Schottky Barriere ist $\emptyset_{bp}$.

Fig. 6a präsentiert ein Beispiel für eine Messung eines elektrischen Stroms $I_D$ als Funktion von $V_{g1}$ von einer Source - Elektrode 402 zu einer Drain - Elektrode 403. An der Drain - Elektrode lag ein Potential von -0,5 Volt an. Die durchgezogene Linie zeigt die Messkurven, die bei einer Spannung $V_{g2}$ = -1V ermittelt wurden. Die gestrichelte Linie zeigt die Messkurven, die bei einer Spannung $V_{g2}$ = +1V ermittelt wurden. Die Strom-Spannungskennlinie $I_d$ - $V_{g1}$ in der Figur 6a zeigt eine Hysterese gegen den Uhrzeigersinn. Diese ist typisch für ferroelektrische Materialien. Es wird also durch das ferroelektrische Material ein für eine Synapse gewünschter Memoryeffekt erzielt. Durch die Änderung der Spannung $V_{g2}$ wird der anfängliche Strom ebenfalls beeinflusst. Dies demonstriert die Gewichtefunktion von $V_{g2}$ einer Synapse.

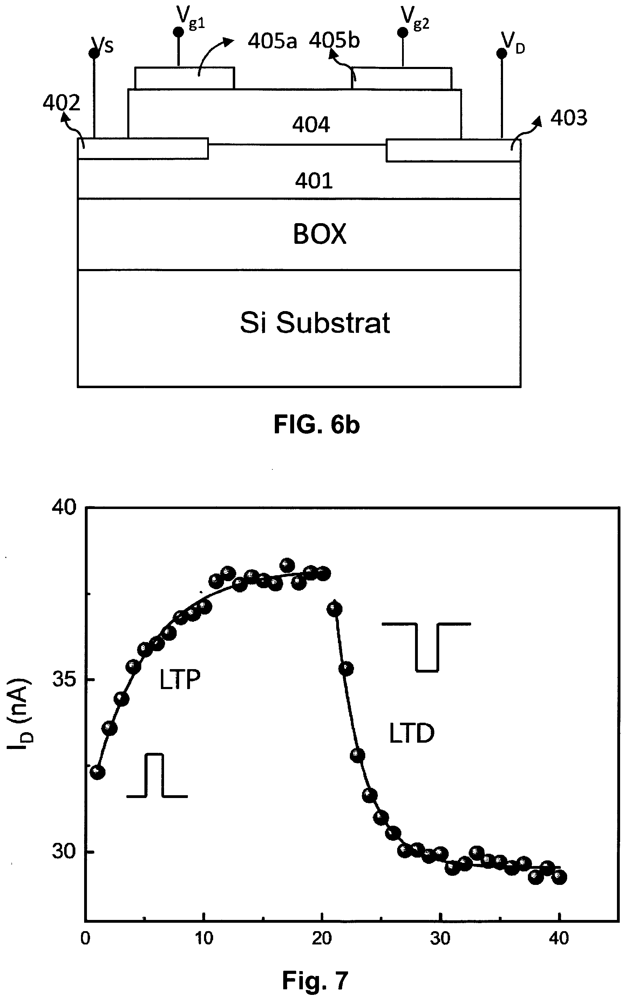

Die in der Figur 6a gezeigten Messkurven wurden mit dem in der Figur 6b gezeigten Bauteil durchgeführt. Eine dünne p-dotierte Siliziumschicht ist durch eine isolierende Schicht von einem Si Substrat getrennt. Dies wird Silicon-on-Insulator genannt und mit SOI abgekürzt. Die isolierende Schicht wird durch "vergrabenes Siliziumoxid" gebildet, die auch buried silicon oxide oder BOX genannt wird. Die Source - Elektrode 402 und die Drain - Elektrode 403 aus einkristallinem $NiSi_2$ gebildet. Die Schichten 402 und 403 sind durch Silizidierung an sehr dünnem Ni auf die dünne, p-dotierte Siliziumschicht 401 aufgetragen. Die Schicht 401 ist 55 nm dick und ist gering p-dotiert. HfZrO wurde als ferroelektrische Schicht 404 abgeschieden und zwar durch ALD (Atomic Layer Deposition). Die Schichtdicke der ferroelektrischen Schicht 404 kann 3 bis 30 nm betragen. Die erste Elektrode 405a und die zweite Elektrode 405b sind aus TiN hergestellt. Die erste Elektrode 405a und die zweite Elektrode 405b dienen als Gate - Elektroden.

Die Fig. 7 zeigt ein Beispiel für die gemessene synaptische Kennlinie des Bauelements aus Fig. 6 unter dem Einfluss eines gepulsten Signals am ersten Gate, also an der ersten Gate - Elektrode 405a. Aufgetragen ist der Strom ID gegen die Pulsanzahl PN. An der ersten Gate - Elektrode wurde also eine Spannung $V_{g1}$ pulsförmig angelegt. Wie in der Figur 7 angedeutet, wird eine Langzeit - Potenzierung (LTP) durch positiv gepulste Signale erzeugt. Eine Langzeit - Depression (LTD) wird durch negativ gepulste Signale erzeugt werden.

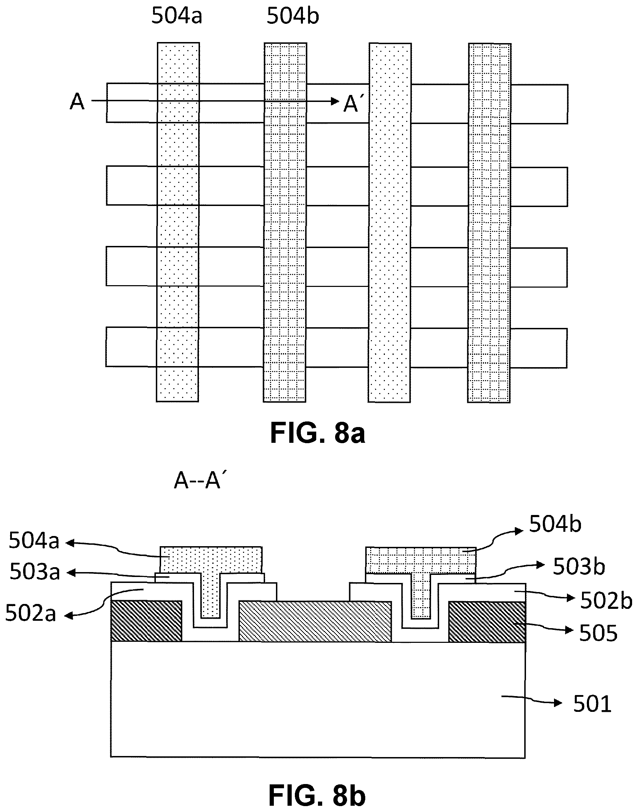

In den Figuren 8a und 8b sind mehrere Synapsen mit einer Crossbarstruktur abgebildet. Eine Querschnittsansicht von A nach A' aus der Figur 8a wird in Figur 8b gezeigt. Zwei Schottky - Dioden einer Synapse weisen eine gemeinsame halbleitende Schicht 501 auf. Eine Metallschicht 502a der ersten Schottky - Diode dient als Source - Elektrode. Eine Metallschicht 502b dient als Drain - Elektrode. Zur Herstellung wurde zunächst auf der halbleitenden Schicht eine elektrisch isolierende Schicht 505 so gefertigt, dass zwei Zugänge zu der halbleitenden Schicht verbleiben. Anschließend wurden die beiden Schichten 502a und 502b so hergestellt, dass diese voneinander elektrisch getrennt sind. Es wurden dann die gezeigten ferroelektrischen Schichten 502a und 502b mit den Gate - Elektroden 504a und 504b hergestellt. Es können bei diesem Aufbau vorteilhaft konventionelle Herstellungstechniken verwendet werden, um eine Vielzahl von Synapsen in Form einer Crossbarstruktur auf technisch einfache Weise herzustellen.

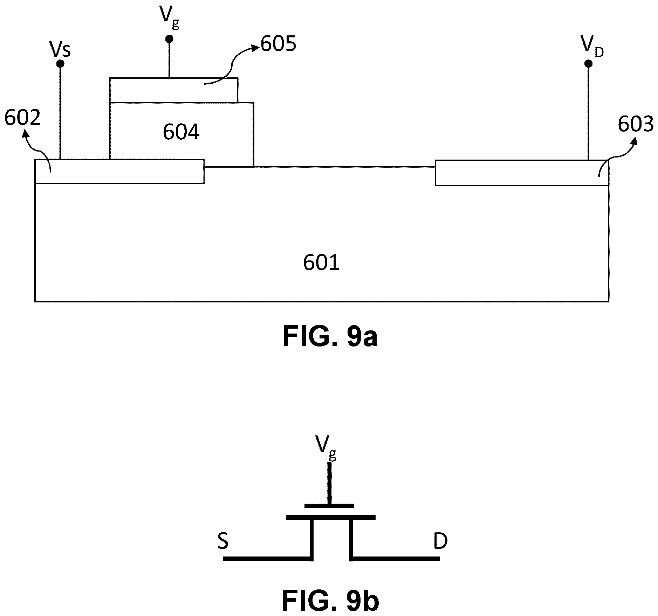

Fig. 9 zeigt ein Beispiel für eine Synapse, welches eine ersten Schottky - Diode umfasst. Die Schottky - Diode umfasst eine aus Metall bestehende Drain - Elektrode 602. Die aus Metall bestehende Drain - Elektrode 602 ist auf einer Halbleiterschicht 601 aufgebracht. Die erste Schottky - Diode kann durch eine ferroelektrische Schicht 604 mit einer Gate - Elektrode 605 erfindungsgemäß mit Hilfe einer Spannung $V_g$ moduliert werden. Eine zweite Schottky - Diode mit der halbleitenden Schicht 601 und der aus Metall bestehenden Drain - Elektrode 603 kann vorhanden sein. Diese kann mit einer Vorspannung $V_D$ in Flussrichtung betrieben werden. Die halbleitende Schicht 601 und die aus Metall bestehende Drain - Elektrode 603 müssen aber nicht so gewählt sein, dass eine zweite Schottky - Diode vorhanden ist. Stattdessen können die halbleitende Schicht 601 und die aus Metall bestehende Drain - Elektrode 603 ein ohmscher Kontakt sein.

Die erste Schottky - Diode 602, 601 wird unter einer Sperrvorspannung betrieben. Dieses synaptische Bauelement arbeitet wie ein Einzelgatetransistor, welcher durch das Symbol aus Fig. 9b dargestellt werden kann.

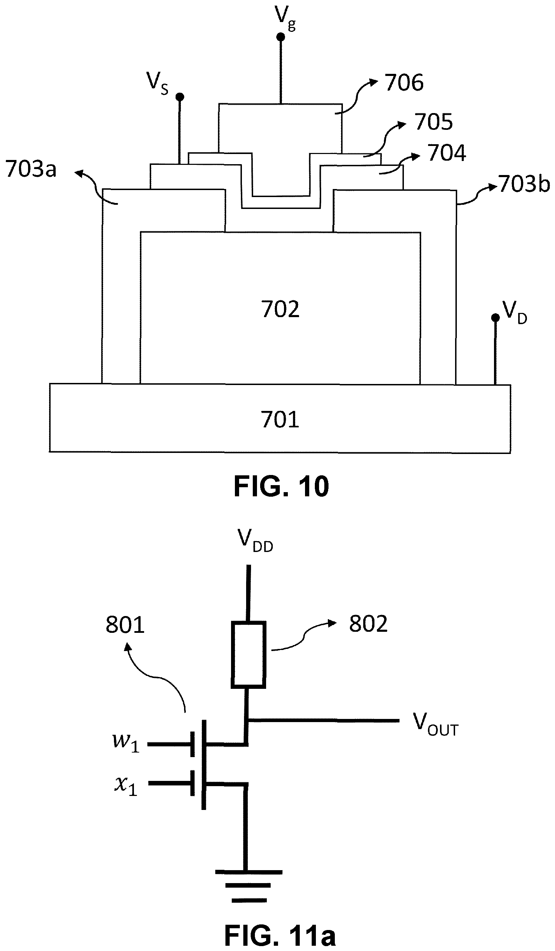

Fig. 10 zeigt ein synaptisches Bauelement in einer vertikalen Anordnung. Eine aus Metall bestehende Schicht 701 kann als Substrat dienen. Die aus Metall bestehende Schicht 701 kann aber auch auf einem Substrat aufgebracht worden sein. Die aus Metall bestehende Schicht 701 dient als Drain - Elektrode. Die aus Metall bestehende Schicht 701 ist daher so eingerichtet, dass diese mit einer Spannung $V_D$ verbunden werden kann. Auf der aus Metall bestehenden Schicht 701 ist eine halbleitende Schicht 702 aufgebracht. Die aus Metall bestehende Schicht 701 und die halbleitende Schicht 702 können eine Schottky - Diode sein. Auf der halbleitenden Schicht ist eine Isolator Schicht 703a, 703b so aufgebracht worden, dass ein Zugang zur halbleitenden Schicht 702 auf der Oberseite verblieben ist. Der Zugang kann auch nachträglich nach der Abscheidung der isolierenden Schicht 703a, 703b geschaffen worden sein, so zum Beispiel durch Ätzen. Auf der Oberseite wurde im Anschluss daran eine metallische Schicht 704 abgeschieden. Diese kontaktiert durch den Zugang hindurch die halbleitende Schicht 702. Die metallische Schicht 704 dient als Source - Elektrode. Diese kann daher mit einer Spannung $V_S$ verbunden werden. Die metallische Schicht 704 und die halbleitende Schicht 702 bilden eine Schottky - Diode. Auf der metallischen Schicht 704 wurde eine ferroelektrische Schicht 705 abgeschieden. Auf der ferroelektrischen Schicht 705 wurde eine metallische Schicht 706 abgeschieden. Die metallische Schicht 706 dient als Gate - Elektrode. Diese kann daher mit einer Spannung verbunden werden.

Die in der Figur 10 gezeigte Struktur kann um 180° gedreht werden. Diese in der Figur 10 gezeigte Struktur ist C2 rotationsinvariant.

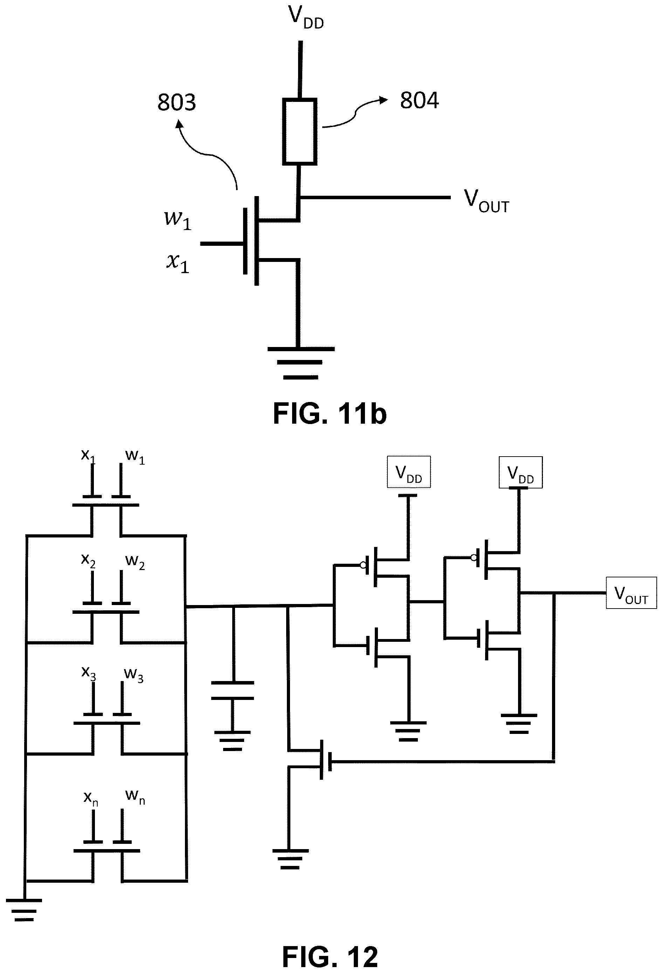

Die Figuren 11a und 11b symbolisieren ein neuronales Bauelement mit einer erfindungsgemäßen Synapse, wobei ein Transistor und ein Widerstand vorhanden sind. Der Transistor kann entweder ein Doppelgatetransistor 801 oder ein Einzelgatetransistor 803 sein. Diese Transistoren repräsentieren ein synaptisches Bauelement. Die Wiederstände 802 und 804 fungieren als pull-up / pull-down Wiederstände. Durch die Anpassung der Leitfähigkeit der Wiederstände kann die Aktivierung eines Neurons angepasst werden.

Fig. 12 stellt ein neuronales Netzwerk mit mehreren erfindungsgemäßen Synapsen und mit konventionellen CMOS Neuronen dar. Die Synapsen werden in der Transistorendarstellung $X_1$, $W_1$, ..., $X_n$, $W_n$ auf der linken Seite gezeigt. Rechts davon wird ein konventionelles neuronales Bauelement dargestellt. Die Synapse kann ein Einzelgatebauelement, wie es in Fig.9 und Fig.10 dargestellt ist, sein. Die Herstellung der Synapsen kann nach dem CMOS Neuronenverfahren erfolgen, um die Hochtemperaturbehandlung während des CMOS Prozesses zu vermeiden. Erfindungsgemäße Synapsen können mit konventionellen Neuronen kombiniert werden, was durch die Figur 12 verdeutlicht wird.

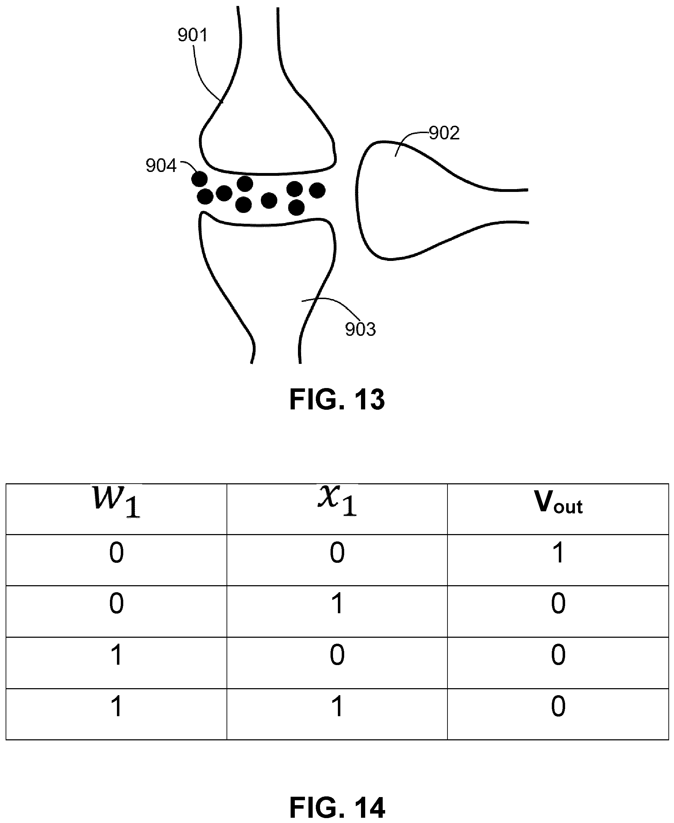

Fig. 13 skizziert eine als Verbindung zwischen Neuron und Neuron dienende Synapse. Ein Signal 904 fließt in eine Richtung und zwar vom präsynaptischen Neuron 901 zum postsynaptischen Neuron 903. Dargestellt ist außerdem ein Neuromodulator 902. Der in der Figur 13 gezeigte Aufbau kann durch die Erfindung realisiert werden. Das erste Gate ($V_{g1}$) aus den Figuren 2 und 3, gebildet durch 105a/205a, kann als präsynaptisches Neuron dienen. Die Source-Elektrode dient als postsynaptisches Neuron. Das zweite Gate ($V_{g2}$), gebildet durch 105b/205b, dient als Neuromodulator. So können Verarbeitungs-, Lern- und Modulationsfunktionen gleichzeitig realisiert werden.

Figur 14 verdeutlicht, wie das in der Figur 11a gezeigte Bauteil als NAND-Gatter mit zwei Eingängen verwendet werden kann.

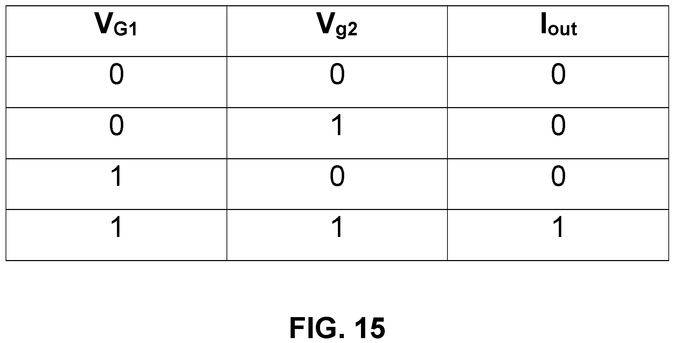

Figur 15 zeigt, wie ein Bauteil gemäß Fig. 2b als AND-Gatter verwendet werden kann, wobei $I_{out}$ der über D abfließende Strom ist.

## Patentansprüche

1. Synaptisches Bauteil für ein neuronales Netzwerk mit einer Schicht aus einem Halbleiter (101, 201) und einer Source - Elektrode (102, 202), die mit der halbleitenden Schicht (101, 201) verbunden ist, und einer Drain - Elektrode (103, 203), die mit der halbleitenden Schicht (101, 201) verbunden ist, wobei die Source - Elektrode (102, 202) von der Drain - Elektrode (103, 203) räumlich getrennt ist, wobei die Source - Elektrode (102, 202) und die halbleitende Schicht (101, 201) eine erste Schottky - Diode bilden, wobei die Source - Elektrode (102, 202) von einer ersten Gate - Elektrode (105a, 205a) durch ferroelektrisches Material (104a, 104b, 204) getrennt ist, **dadurch gekennzeichnet, dass** die Drain - Elektrode (103, 203) mit der halbleitenden Schicht (101, 201) eine zweite Schottky - Diode bilden, und dass die Drain - Elektrode (103, 203) von einer zweiten Gate - Elektrode (105b, 205b) durch ferroelektrisches Material (104b, 204) getrennt ist und wobei die erste Gate - Elektrode (105a, 205a) von der zweiten Gate - Elektrode (105b, 205b) räumlich getrennt ist.

2. Bauteil nach dem vorhergehenden Anspruch, **dadurch gekennzeichnet, dass** sich die Source - Elektrode (102, 202) und die Drain - Elektrode (103, 203) auf einer Seite der halbleitenden Schicht (101, 201) und/oder bei gegenüberliegenden Enden der halbleitenden Schicht (101, 201) befinden.

3. Bauteil nach einem der vorhergehenden Ansprüche, **dadurch gekennzeichnet, dass** sich die halbleitende Schicht (401) oberhalb eines Substrats befindet oder dass die halbleitende Schicht ein Substrat (601) ist.

4. Bauteil nach einem der vorhergehenden Ansprüche, **dadurch gekennzeichnet, dass** die halbleitende Schicht (101, 201, 401) eine Halbleiterheterostruktur ist.

5. Bauteil nach einem der vorhergehenden Ansprüche, **dadurch gekennzeichnet, dass** ferroelektrisches Material als Schicht (104a, 104b, 204) vorliegt, die sich zumindest teilweise auf der halbleitenden Schicht (101, 201) befindet.

6. Bauteil nach einem der vorhergehenden Ansprüche, **dadurch gekennzeichnet, dass** ferroelektrisches Material als Schicht (104a, 104b, 204) vorliegt, die sich zumindest teilweise auf der Source- Elektrode (102, 202) und/oder der Drain - Elektrode (103, 203) befindet.

7. Bauteil nach den beiden vorhergehenden Ansprüchen, **dadurch gekennzeichnet, dass** das ferroelektrische Material als eine einzige Schicht (204) vorliegt, die sich sowohl zumindest teilweise auf der Source - Elektrode (102, 202) als auch zumindest teilweise auf der Drain - Elektrode (103, 203) befindet.

8. Bauteil nach einem der vorhergehenden Ansprüche, **dadurch gekennzeichnet, dass** ferroelektrisches Material als Schicht (104a, 104b, 204) vorliegt und sich die erste Gate - Elektrode (105a, 205a) und/oder die zweite Gate - Elektrode (105b, 205b) auf einer Seite der ferroelektrischen Schicht (104a, 104b, 204) befinden und die Source - Elektrode (102, 202) und/oder die Drain - Elektrode (103, 203) sich auf der gegenüberliegenden Seite der ferroelektrischen Schicht (104a, 104b, 204) befinden.

9. Bauteil nach einem der vorhergehenden Ansprüche, **dadurch gekennzeichnet, dass** das Bauteil mit wenigstens einem weiteren Bauteil nach einem der vorhergehenden Ansprüche elektrisch seriell oder elektrisch parallel zur Bildung einer Crossbarstruktur verbunden ist.

10. Bauteil nach einem der vorhergehenden Ansprüche, **dadurch gekennzeichnet, dass** das ferroelektrische Material ausgewählt ist aus: dotierten $HfO_2$ Ferroelektrikum, einem Perowskit Ferroelektrikum, einem organischen Ferroelektrikum, und dass das Metall für eine Schottky - Diode ausgewählt ist aus: Al, Ag, Au, Cu, Cr, Mo, Ni, Nb, Pt, Ti, Ni, TiN, TaN, oder einer Metallhalbleiterlegierung wie Silizide, Germanide, Metall-SiGeSn-Legierungen.

11. Bauteil nach einem der vorhergehenden Ansprüche, **dadurch gekennzeichnet, dass** die halbleitende Schicht (501) teilweise mit einer Schicht aus elektrisch isolierendem Material (505, 703a, 703b) abgedeckt ist.

12. Neuronales Netzwerk umfassend ein synaptisches Bauteil nach einem der vorhergehenden Ansprüche und ein Neuron, das mit dem synaptischen Bauteil elektrisch verbunden ist.

13. Verfahren für den Betrieb eines synaptischen Bauteils nach einem der vorhergehenden Ansprüche, indem die erste Schottky-Diode (101, 102; 201, 202) in Sperrrichtung geschaltet wird und an die erste Gate-Elektrode (105a, 205a) eine elektrische Spannung ($V_{g1}$) pulsförmig angelegt wird.

**Claims**

1. Synaptic component for a neural network having a layer of a semiconductor (101, 201) and a source electrode (102, 202) connected to the semiconducting layer (101, 201) and a drain electrode (103, 203) connected to the semiconducting layer (101, 201), wherein the source electrode (102, 202) is spatially separated from the drain electrode (103, 203), wherein the source electrode (102, 202) and the semiconducting layer (101, 201) form a first Schottky diode, wherein the source electrode (102, 202) is separated from a first gate electrode (105a, 205a) by ferroelectric material (104a, 104b, 204), **characterized in that** the drain electrode (103, 203) forms with the semiconducting layer (101, 201) a second Schottky diode and **in that** the drain electrode (103, 203) is separated from a second gate electrode (105b, 205b) by ferroelectric material (104b, 204), and wherein the first gate electrode (105a, 205a) is spatially separated from the second gate electrode (105b, 205b).

2. Component according to the preceding claim, **characterized in that** the source electrode (102, 202) and the drain electrode (103, 203) are located on one side of the semiconducting layer (101, 201) and/or at opposite ends of the semiconducting layer (101, 201).

3. Component according to one of the preceding claims, **characterized in that** the semiconducting layer (401) is located above a substrate or **in that** the semiconducting layer is a substrate (601).

4. Component according to one of the preceding claims, **characterized in that** the semiconducting layer (101, 201, 401) is a semiconductor heterostructure.

5. Component according to one of the preceding claims, **characterized in that** ferroelectric material is present as a layer (104a, 104b, 204) which is at least partially located on the semiconducting layer (101, 201).

6. Component according to one of the preceding claims, **characterized in that** ferroelectric material is present as a layer (104a, 104b, 204) which is at least partially located on the source electrode (102, 202) and/or the drain electrode (103, 203).

7. Component according to the two preceding claims, **characterized in that** the ferroelectric material is present as a single layer (204) which is located both at least partially on the source electrode (102, 202) and at least partially on the drain electrode (103, 203).

8. Component according to one of the preceding claims, **characterized in that** ferroelectric material is present as a layer (104a, 104b, 204) and the first gate electrode (105a, 205a) and/or the second gate electrode (105b, 205b) are located on one side of the ferroelectric layer (104a, 104b, 204) and the source electrode (102, 202) and/or the drain electrode (103, 203) are located on the opposite side of the ferroelectric layer (104a, 104b, 204).

9. Component according to one of the preceding claims, **characterized in that** the component is electrically connected to at least one further component according to one of the preceding claims in series or in parallel to form a crossbar structure.

10. Component according to one of the preceding claims, **characterized in that** the ferroelectric material is selected from: doped $HfO_2$ ferroelectric, a perovskite ferroelectric, an organic ferroelectric, and that the metal for a Schottky diode is selected from: Al, Ag, Au, Cu, Cr, Mo, Ni, Nb, Pt, Ti, Ni, TiN, TaN, or a metal semiconductor alloy such as silicides, germanides, metal-SiGeSn alloys.

11. Component according to one of the preceding claims, **characterized in that** the semiconducting layer (501) is partially covered with a layer of electrically insulating material (505, 703a, 703b).

12. Neural network comprising a synaptic component according to one of the preceding claims and a neuron electrically connected to the synaptic component.

13. Method of operating a synaptic component according to one of the preceding claims in which the first Schottky diode (101, 102; 201, 202) is connected in reverse direction and an electric voltage ($V_{g1}$) is applied to the first gate electrode (105a, 205a) in a pulsed manner.

**Revendications**

1. Partie construction synaptique pour un réseau neuronal avec une couche d'un semi-conducteur (101, 201) et une électrode de source (102, 202) qui est connectée à la couche semi-conductrice (101, 201) et une électrode de drain (103, 203) qui est connectée à la couche semi-conductrice (101, 201), dans lequel l'électrode de source (102, 202) est séparée spatialement de l'électrode de drain (103, 203), dans lequel l'électrode de source (102, 202) et la couche semi-conductrice (101, 201) forment une première diode Schottky, dans lequel l'électrode de source (102, 202) est séparée d'une première électrode de grille (105a, 205a) par un matériau ferroélectrique (104a, 104b, 204),

    **caractérisée en ce que** l'électrode de drain (103, 203) forme une seconde diode Schottky avec la couche semi-conductrice (101, 201), et **en ce que** l'électrode de drain (103, 203) est séparée d'une deuxième électrode de grille (105b, 205b) par un matériau ferroélectrique (104b, 204), et dans lequel la première électrode de grille (105a, 205a) est séparée spatialement de la deuxième électrode de grille (105b, 205b).

2. Partie construction selon la revendication précédente, **caractérisée en ce que** l'électrode de source (102, 202) et l'électrode de drain (103, 203) se trouvent sur un côté de la couche semi-conductrice (101, 201) et/ou aux extrémités opposées de la couche semi-conductrice (101, 201).

3. Partie construction selon l'une des revendications précédentes, **caractérisée en ce que** la couche semi-conductrice (401) se trouve au-dessus d'un substrat ou **en ce que** la couche semi-conductrice est un substrat (601).

4. Partie construction selon l'une des revendications précédentes, **caractérisée en ce que** la couche semi-conductrice (101, 201, 401) est une hétérostructure semi-conductrice.

5. Partie construction selon l'une des revendications précédentes, **caractérisée en ce que** le matériau ferroélectrique est présent comme couche (104a, 104b, 204) qui se trouve au moins partiellement sur la couche semi-conductrice (101, 201).

6. Partie construction selon l'une des revendications précédentes, **caractérisée en ce que** le matériau ferroélectrique est présent comme couche (104a, 104b, 204) qui se trouve au moins partiellement sur l'électrode de source (102, 202) et/ou l'électrode de drain (103, 203).

7. Partie construction selon les deux revendications précédentes, **caractérisée en ce que** le matériau ferroélectrique est présent comme une couche unique (204) qui se trouve à la fois au moins partiellement sur l'électrode de source (102, 202) et au moins partiellement sur l'électrode de drain (103, 203).

8. Partie construction selon l'une des revendications précédentes, **caractérisée en ce que** du matériau ferroélectrique est présent comme couche (104a, 104b, 204) et **en ce que** la première électrode de grille (105a, 205a) et/ou la deuxième électrode de grille (105b, 205b) se trouvent d'un côté de la couche ferroélectrique (104a, 104b, 204) et l'électrode de source (102, 202) et/ou l'électrode de drain (103, 203) se trouvent du côté opposé de la couche ferroélectrique (104a, 104b, 204).

9. Partie construction selon l'une des revendications précédentes, **caractérisée en ce que** la partie construction est connectée électriquement en série ou électriquement en parallèle avec au moins une autre partie construction selon l'une des revendications précédentes pour former une structure de barre transversale.

10. Partie construction selon l'une des revendications précédentes, **caractérisée en ce que** le matériau ferroélectrique est choisi parmi : un ferroélectrique $HfO_2$ dopé, un ferroélectrique perovskite, un ferroélectrique organique, et **en ce que** le métal pour une diode Schottky est choisi parmi : Al, Ag, Au, Cu, Cr, Mo, Ni, Nb, Pt, Ti, Ni, TiN, TaN, ou un alliage métal-semi-conducteur comme les siliciures, les germanures, les alliages métal-SiGeSn.

11. Partie construction selon l'une des revendications précédentes, **caractérisée en ce que** la couche semi-conductrice (501) est partiellement recouverte d'une couche de matériau électriquement isolant (505, 703a, 703b).

12. Réseau neuronal comprenant une partie construction synaptique selon l'une des revendications précédentes et un neurone qui est connecté électriquement à la partie construction synaptique.

13. Procédé de fonctionnement d'une partie construction synaptique selon l'une des revendications précédentes, dans lequel la première diode Schottky (101, 102 ; 201, 202) est commutée en sens inverse et une tension électrique ($V_{g1}$) est appliquée de manière pulsée à la première électrode de grille

**EP 4 133 419 B1**

(105a, 205a).

**FIG. 1**

**FIG. 2a**

**FIG. 2b**

$V_S$

$V_{g1}$

205a   205b

$V_{g2}$

$V_D$

202

204

203

201

# FIG. 3

$V_{gi} > 0$

305

304

302

301

# FIG. 4a

FIG. 4b

FIG. 5a

302

301

$\phi_{bn}$

$\phi_{bp}$

Ec

Ev

## FIG. 5b

$I_D$ (A)

$V_{g2}$=-1V

$V_{g2}$=+1V

$V_D$=-0.5V

$V_{g1}$ (V)

## FIG. 6a

**FIG. 6b**

**Fig. 7**

504a    504b

**FIG. 8a**

A--A′

**FIG. 8b**

**FIG. 9a**

**FIG. 9b**

**FIG. 10**

**FIG. 11a**

$$V_{DD}$$

803

804

$$V_{OUT}$$

$$w_1$$

$$x_1$$

## FIG. 11b

$$x_1 \quad w_1$$

$$x_2 \quad w_2$$

$$x_3 \quad w_3$$

$$x_n \quad w_n$$

$$V_{DD} \quad V_{DD}$$

$$V_{OUT}$$

## FIG. 12

901

904

902

903

**FIG. 13**

| $w_1$ | $x_1$ | $V_{out}$ |
|-------|-------|-----------|
| 0 | 0 | 1 |
| 0 | 1 | 0 |
| 1 | 0 | 0 |
| 1 | 1 | 0 |

**FIG. 14**

| $V_{G1}$ | $V_{g2}$ | $I_{out}$ |
|:---:|:---:|:---:|
| 0 | 0 | 0 |
| 0 | 1 | 0 |
| 1 | 0 | 0 |
| 1 | 1 | 1 |

FIG. 15

**IN DER BESCHREIBUNG AUFGEFÜHRTE DOKUMENTE**

**In der Beschreibung aufgeführte Patentdokumente**

- WO 2019139598 A1
- US 2019198617 A1
- CN 208922326 U
- WO 2019147859 A2
- EP 0529565 B1
- US 2019164597 A1

**In der Beschreibung aufgeführte Nicht-Patentliteratur**

- **BIN TANG** ; **SABIR HUSSAIN** ; **RUI XU** ; **ZHIHAI CHENG** ; **JIANHUI LIAO** ; **QING CHEN**. Novel Type of Synaptic Transistors Based on a Ferroelectric Semiconductor Channel. *ACS Appl. Mater. Interfaces*, 2020, vol. 12 (22), 24920-24928, https://doi.org/10.1021/acsami.9b23595